# EUROPEAN PATENT APPLICATION

(11) **EP 2 026 464 A1**
(43) Date of publication of application: **18.02.2009**
(21) Application number: 08161333.3
(22) Date of filing: 29.07.2008
(51) Int. Cl.: H03K 17/79, F16K 31/04, F15B 13/044

(54) **A control circuit for the motor of a motorized hydraulic valve, particularly for boilers and the like**

(30) Priority: 01.08.2007 IT TO20070570
(71) Applicant: BITRON S.p.A., 10122 Torino (IT)
(72) Inventor: Fontana, Riccardo, 10141 Torino (IT); Bosco, Enrico, 10132 Torino (IT)
(74) Representative: Quinterno, Giuseppe

(57) **Abstract**

The control circuit comprises a pair of terminals (A, B) connected to an alternating voltage supply, the motor (M) being connected between these terminals. A first and a second current path (C, D), essentially in parallel with each other and in series with the motor (M), are formed between these terminals. Each current path (C, D) comprises a corresponding switch (c, d) which can be controlled selectively by the motor (M) in such a way that each switch closes when the motor (M) sets the valve to a corresponding operating condition. The current paths (C, D) include electrically operated switches which can selectively connect one of said paths (C, D) to a supply terminal (B). These switches comprise a first and a second optical triac (OT1, OT2) which arc connected in series in the first and second current path (C, D) respectively, and which arc associated, respectively, with a first and a second controlling emitting diode (D1, D2).

## Description

The present invention relates to a control circuit for the switching motor of a motorized hydraulic valve, particularly for boilers and the like.

Motorized hydraulic valves, typically of the three-way type, are used in boilers, and particularly in wall-mounted boilers, for selectively switching the flow of water supplied from a heat exchanger towards a heating circuit including one or more radiators, or towards a domestic hot water supply circuit.

More specifically, the invention relates to a control circuit comprising:
a pair of terminals intended to be connected to an alternating voltage supply, the valve motor being connected between these terminals, and
a first and a second current path, positioned essentially in parallel with each other and in series with the motor between said terminals; each current path comprising a corresponding switch which can be controlled selectively by the valve motor, in such a way that each switch closes when the motor sets the valve to a corresponding operating condition;
said current paths including electrically operated switch means for selectively connecting one or other of the paths to a supply terminal.

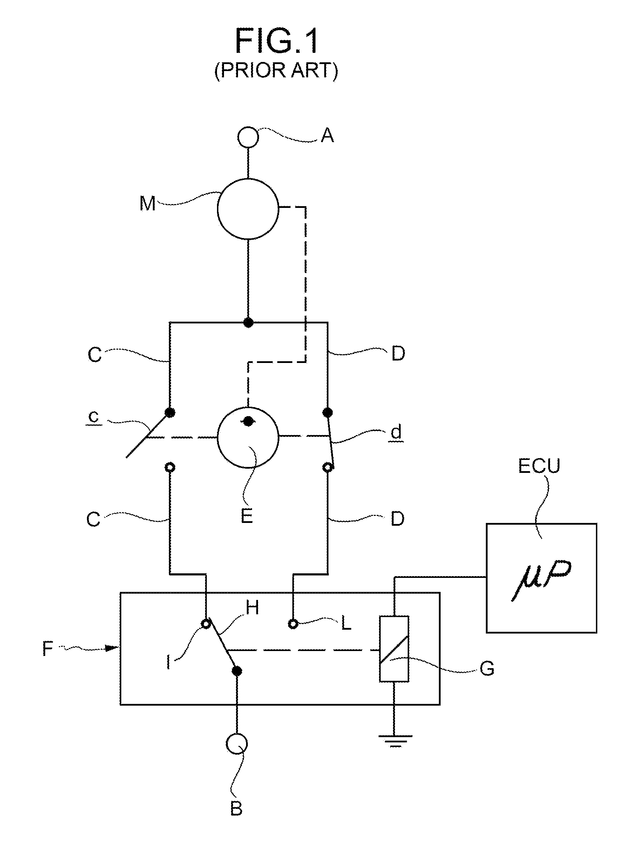

A control circuit of this type according to the prior art is illustrated by way of example in Figure 1 of the appended drawings. With reference to this drawing, the motor M for switching a motorized hydraulic valve of a known type (not shown) is connected between two supply terminals A and B which are intended to be connected to an alternating voltage source. Two current paths C and D, essentially parallel to each other, are formed between the terminals A and B, in series with the motor M. These paths include corresponding switches c and d, which can be controlled selectively by the motor M, by means of a rotating cam member E for example, in such a way that each of the switches closes when the motor M sets the associated hydraulic valve to a corresponding operating condition.

Between the switches c and d and the supply terminal B, the current paths C and D are connected to a changeover relay, indicated as a whole by F. This relay, which is of a known type, comprises an excitation coil G which controls the position of a moving contact H which can be moved selectively between two fixed contacts I and L, connected to the current paths C and D respectively.

The coil G of the changeover relay F is controlled by an output of an electronic control unit ECU, typically of the microprocessor type.

The prior art circuit described above requires the use of a changeover relay which can withstand high currents (of 10 A for example) because it has a very high level of insulation. For example, the spacing ("clearance") between the coil G and the moving contact H must be more than 5 mm.

The changeover relay F is an electromechanical component which, in practice, must be manually mounted on a printed circuit board and connected thereto.

In addition to the disadvantages typical of electromechanical switching devices (the possibility of arc discharges, burnout, possible binding of contacts, etc.), the costs of fitting this type of relay are high.

One object of the present invention is to overcome the aforementioned disadvantages of the prior art circuits.

This and other objects are achieved according to the invention by means of a control circuit of the type specified above, characterized in that the aforesaid switch means comprise a first and a second optical triac, which are connected in series in the first and second current path respectively, and which are associated with a first and second controlling emitting diode respectively.

Optical triacs and the associated emitting diodes are solid-state components and can conveniently be produced by SMD technology, making it a very simple matter to fit them automatically on printed circuit boards.

According to a further feature, the aforesaid emitting diodes are connected to a single three-state output of a microprocessor processing and control unit, via a control circuit.

Other features and advantages of the invention will be made clear by the following detailed description, provided purely by way of non-limiting example, with reference to the appended drawings, in which:
Figure 1, described above, shows the diagram of a prior art control circuit;
Figure 2 shows the diagram of a control circuit according to the present invention; and
Figure 3 is a partial circuit diagram showing a procedure for controlling the control circuit according to the present invention.

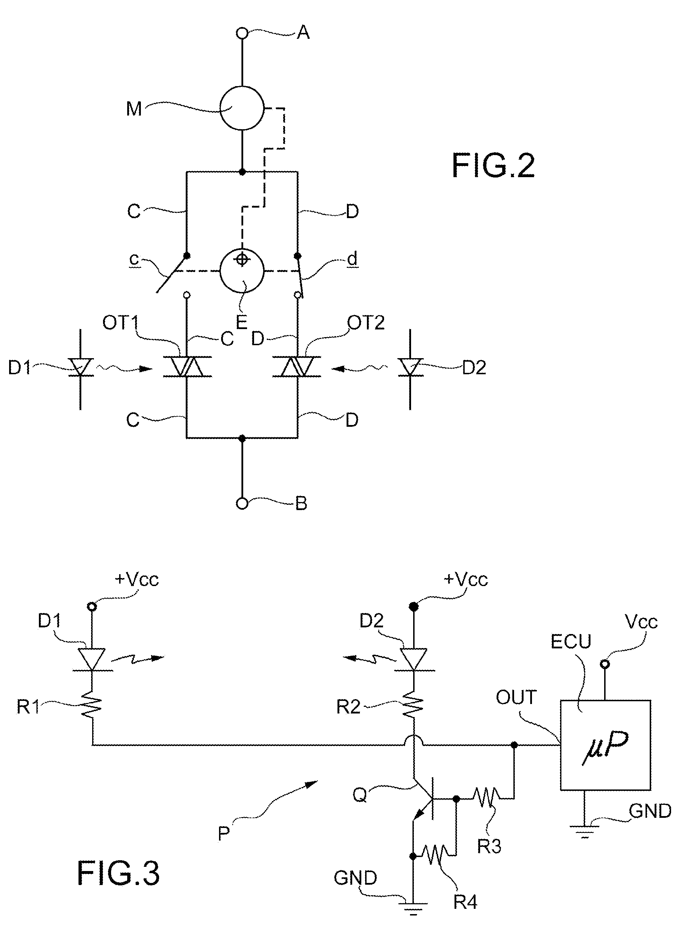

In Figure 2, components already described in relation to Figure 1 have been given the same alphanumerical symbols as those used previously.

In the control circuit according to the invention shown in Figure 2, a first and a second optical triac OT1 and OT2 are connected in series in the first and second current path C and D respectively, between the switches c and d and the supply terminal B.

The optotriacs OT1 and OT2 are associated with respective controlling emitting diodes D1 and D2, by means of which an electronic control unit, not shown in Figure 2, can selectively cause one or other of the two optical triacs to conduct.

In Figure 2, the control circuit is shown in an idle condition, in which the switch d is closed, but since the optical triac OT2 is not excited, the motor M is stopped, and is, in particular, in a position corresponding to one of the two operating conditions of the associated hydraulic valve, which is not shown.

Starting from this condition, the electronic control unit excites the emitting diode D2, which in turn causes the optical triac OT2 to conduct, in order to cause the hydraulic valve to switch to the other operating condition. A current can then flow in the motor M: this motor causes the hydraulic valve to switch to the new operating condition. When this condition is reached, the cam member E, which is also driven by the motor M, causes the switch d to open and causes the switch c to close. Consequently the motor M stops and the optical triac OT2 becomes non-conducting. The control circuit as a whole is then in its other possible idle condition.

In order to switch the motorized hydraulic valve back to the initial operating condition, the electronic control unit excites the emitting diode D1, which in turn causes the initiation of conduction in the optical triac OT1. The motor M is then supplied with power again, causing the hydraulic valve to switch towards the initial operating condition; when this condition is reached, the cam member E again causes the switch c to open and causes the switch d to close. At this point, the control circuit returns to the idle condition to which Figure 2 relates.

Figure 3 shows a possible embodiment of the control of the emitting diodes D 1 and D2 by a microprocessor-based processing and control unit ECU having an output OUT with three states ("0", "1", and "open circuit" or "high impedance").

In the illustrated example, the diodes D1 and D2 are connected to the output OUT of the unit ECU by a control circuit indicated as a whole by P. This circuit comprises a first and a second resistor R1 and R2 connected to the cathode of the diode D1 and of the diode D2 respectively, the anodes of the diodes being connected to a continuous supply voltage source V_{cc}. Two further resistors R3 and R4 are connected between the resistor R1 and the ground GND.

A transistor Q has its base connected to the connection between the resistors R3 and R4, while its emitter is connected to the ground GND and its collector is connected to the diode D2 through the second resistor R2.

The output OUT of the microprocessor unit ECU is connected to the connection between the resistors R1 and R3.

The resistances of the resistors R1-R4 are specified in such a way that the circuit described above can operate in the following way:
- when the output OUT of the unit ECU is at level "0", diode D1 is active, while diode D2 remains inactive because the transistor Q is non-conducting;
- when the output OUT of the unit ECU is at level "1", diode D1 is inactive, while diode D2 is activated because the transistor Q is conducting; and
- when the output OUT of the unit ECU is in the "high impedance" state, both diodes D1 and D2 are inactive.

Naturally, the principle of the invention remaining the same, the forms of embodiment and the details of construction may be varied widely with respect to those described and illustrated, which have been given purely by way of non-limiting example, without thereby departing from the scope of the invention as defined by the attached claims.

## Claims

1. A control circuit for the switching motor (M) of a motorized hydraulic valve, particularly for boilers and the like, comprising:
a pair of terminals (A, B) intended to be connected to an alternating voltage supply, the motor (M) being connected between these terminals, and
a first and a second current path (C, D), positioned essentially in parallel with each other and in series with the motor (M) between said terminals (A, B); each current path (C, D) comprising a corresponding switch (c, d) which can be controlled selectively by the motor (M) in such a way that each switch closes when the motor (M) sets the valve to a corresponding operating condition;
said current paths (C, D) including electrically operated switch means for selectively connecting one or other of these paths (C, D) to a supply terminal (B); the circuit being **characterized in that** said switch means comprise a first and a second optical triac (OT1, OT2) which are connected in series in the first and second current path (C, D) respectively, and which are associated, respectively, with a first and a second controlling emitting diode (D1, D2).

2. A control circuit according to Claim 1, in which said emitting diodes (D1, D2) are connected to a single three-state output (OUT) of a microprocessor-based processing and control unit (ECU), by means of a control circuit (P).

3. A control circuit according to Claim 2, in which said emitting diodes (D1, D2) have their anodes connected to a continuous voltage source (V_{cc}), and the control circuit (P) comprises:
a first and a second resistor (R1, R2) connected to the cathode of the first and second emitting diode (D1, D2) respectively;
a third and a fourth resistor (R3, R4) connected between the first resistor (R1) and the ground (GND); and
a transistor (Q) having its base connected between the third and the fourth resistor (R3, R4), while its emitter is connected to the ground (GND) and its collector is connected to the second resistor (R2);
said output (OUT) of the microprocessor-based processing and control unit (ECU) being connected to the connection between the first and the third resistor (R1, R3).

4. A control circuit according to any one of the preceding claims, in which the optical triacs (OT1, OT2) and the associated emitting diodes (D1, D2) are produced by SMD technology.

5. A control circuit for the switching motor of a motorized hydraulic valve, particularly for boilers and the like, substantially as described and illustrated, and for the specified purposes.
